# EUROPEAN PATENT APPLICATION

(11) **EP 4 841 637 A1**
(43) Date of publication of application: **18.11.2026**
(21) Application number: 25189322.8
(22) Date of filing: 14.07.2025
(51) Int. Cl.: G11C 29/50, G11C 11/56, G11C 16/34, G11C 29/02, G11C 29/42

(54) **MEMORY DEVICE AND OPERATING METHOD WITH MARGINAL MONITORING OPERATION THEREOF**

(30) Priority: 12.05.2025 US 202519205983
(71) Applicant: Winbond Electronics Corp., Taichung City (TW)
(72) Inventor: ADMON, Itay, Taichung City (TW); TASHER, Nir, Taichung City (TW); LAZAR, Binyamin, Taichung City (TW); KALUZHNY, Uri, Taichung City (TW)
(74) Representative: Becker, Eberhard

(57) **Abstract**

A memory device (100) includes a memory array (110), a sense amplifier (140) and a built-in self-test (BIST) circuit (130). The BIST circuit (130) is connected to the memory array (110) and the sense amplifier (140), and is configured to perform a first operation on at least one memory cell among the memory cells using a first threshold to generate a first result and to perform a second operation on the at least one memory cell among the memory cells using a second threshold to generate a second result. The second threshold is greater than the first threshold. The BIST circuit (130) determines that the at least one memory cell are marginal in response to determining that the first result is different from the second result.

## Description

### BACKGROUND

### Technical Field

The disclosure relates to a memory device, and more particularly to a non-volatile memory device and an operating method for in-field marginal monitoring that can reduce the margins required to ensure endurance and data retention, reduce the overall die size, and increase the reliability of the memory device.

### Description of Related Art

A non-volatile memory such as a flash memory uses floating gate transistors to store data. These transistors store a charge voltage that defines the logic value of a memory cell in the flash memory. During a read operation, this charge voltage of the memory cell is compared with a threshold to determine its logic value. To ensure the stability and data retention of the flash memory over time, a margin of error is maintained to prevent ambiguity when comparing the charge voltage to the threshold.

However, as performance of memory cells deteriorate over time, the charge voltages of some memory cells may become too close to the threshold, resulting in ambiguity when comparing these charge voltages to the threshold. As a result, the stability and reliability of the flash memory are reduced. To ensure a safe margin of error, the flash memory may be designed with a large margin of error; however, this results in overdesign that might increase the die size and power consumption of the flash memory.

Conventional flash memory may implement some mechanisms to detect errors that have occurred in the flash memory. However, conventional flash memory cannot predict errors that are about to occur but have not occurred yet. Furthermore, conventional flash memory may be tested for detecting errors using specialized testing equipment at a laboratory environment; however, it is unable to implement an in-field monitoring method executed within the flash memory for monitoring the health of the memory cells.

It is desirable to have a novel and creative design for a memory device and an in-field marginal monitoring operation that can monitor the health of the memory cells and perform corrective measures to prevent failures before they occur, thereby improving the reliability of the memory device, especially for safety-critical applications.

### SUMMARY

A memory device and an operating method for monitoring the health of memory cells, capable of reducing the margins required to ensure endurance, reliability and data retention, reducing the overall die size, and increasing the reliability of the memory device, are introduced.

In some embodiments, an operating method adapted to a memory device comprising a plurality of memory cell is introduced. The operating method includes steps of performing a marginal monitoring operation on at least one memory cell among the memory cells of the memory device. The marginal monitoring operation includes: performing a first operation on the at least one memory cell among the memory cells using a first threshold to generate a first result; performing a second operation on the at least one memory cell among the memory cells using a second threshold to generate a second result, wherein the second threshold is greater than the first threshold; and determining that the at least one memory cell are marginal in response to determining that the first result is different from the second result.

In some embodiments, a memory device includes a memory array, a sense amplifier and a built-in self-test (BIST) circuit. The memory array includes a plurality of memory cells. The sense amplifier is connected to the memory cells and is configured to read values stored in the memory cells. The BIST circuit is connected to the memory cells and is configured to perform a first operation on at least one memory cell among the memory cells using a first threshold to generate a first result, perform a second operation on the at least one memory cell among the memory cells using a second threshold to generate a second result, wherein the second threshold is greater than the first threshold, and determine that the at least one memory cell are marginal in response to determining that the first result is different from the second result.

In the above embodiments of the disclosure, an operating method is adapted to a memory device to predict the health of memory cells before a failure occurs in the memory device during the memory device's lifetime (i.e., in-field). The operating method may determine a marginal status of at least one memory cell based on a comparison between a first result and a second result. The first result is obtained by performing a first operation on at least one memory cell using the first threshold, and the second result is obtained by performing a second operation on the same memory cell using the second threshold. Corrective measures may be taken to restore the proper functionality of marginal memory cells. In this way, the operating method may increase the reliability and stability of the memory device for safety-critical applications. Additionally, it may reduce the margin of error required to ensure the endurance and data retention of memory cells. Consequently, the die size of the memory device is reduced. The operating method can be performed on a memory block level to reduce the time required for execution.

To make the above features and advantages provided in one or more of the embodiments of the disclosure more comprehensible, several embodiments accompanied with drawings are described in detail as follows.

### BRIEF DESCRIPTION OF THE DRAWINGS

FIG. 1 is a schematic diagram of a memory device in accordance with some embodiments.
FIG. 2 is a diagram illustrating a charge voltage distribution of memory cells of a memory device in accordance with some embodiments.
FIG. 3 is a flowchart diagram of a marginal monitoring operation of an operating method in accordance with some embodiments.
FIG. 4 is a flowchart diagram of an operating method adapted to a memory device in accordance with some embodiments.

### DESCRIPTION OF THE EMBODIMENTS

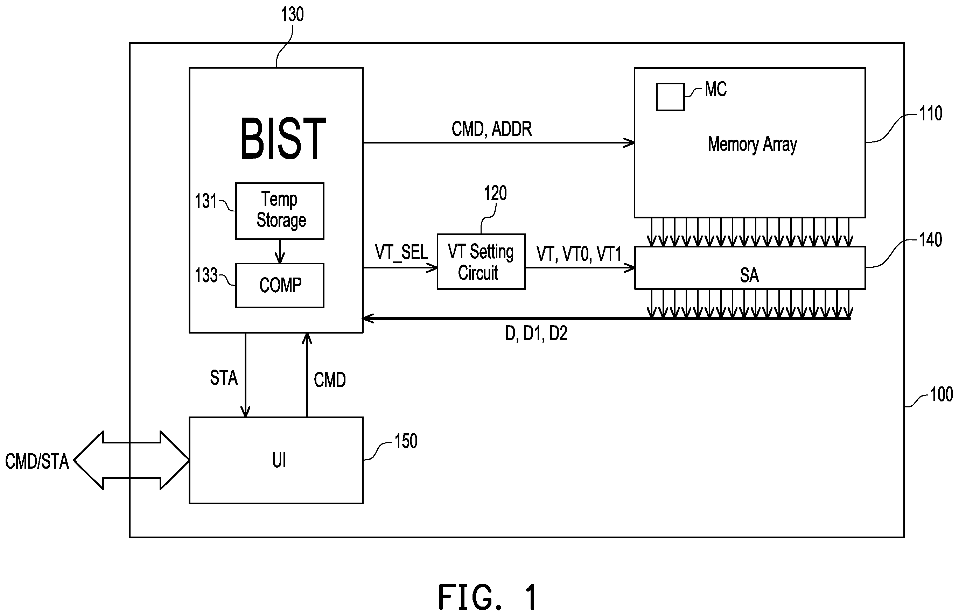

FIG. 1 illustrates a schematic diagram of a memory device 100 in accordance with some embodiments. The memory device 100 may include a memory array 110, a threshold setting circuit 120, a built-in self-test (BIST) circuit 130, a sense amplifier (SA) circuit 140, and a user interface (UI) 150. The memory array 110 may include a plurality of memory cells MC arranged in rows and columns (not shown). The memory cells MC can be single-level cells (SLCs) or multi-level cells (MLCs) for storing single-level logic data or multi-level logic data. The memory cells MC can be non-volatile memory cells or flash memory cells, such as NAND flash memory cells or NOR flash memory cells. The memory array 110 may further include a plurality of word lines, bit lines, and source lines (not shown) and additional components connected to the memory cells MC. Memory operations, such as read, write, or erase operations, may be performed on the memory cells MC through the word lines, bit lines, and source lines and additional components. Each memory cell MC may have an associated address, which can be used to identify the memory cell MC for memory operations. To perform a read operation on a specific memory cell MC, a read command CMD and an address ADDR identifying the specific memory cell may be sent to the memory array 110.

The threshold setting circuit 120 is connected to the BIST circuit 130 and the SA circuit 140. The threshold setting circuit 120 may receive a threshold selecting signal VT_SEL from the BIST circuit 130, generate a threshold based on the threshold selecting signal VT_SEL, and output the generated threshold to the SA circuit 140. During the normal operating mode of the memory device 100, the threshold setting circuit 120 may generate and output a threshold VT (i.e., the normally-operating threshold) to the SA circuit 140 to perform read operations. During the marginal monitoring mode of the memory device 100, the threshold setting circuit 120 may output a first threshold VT0 to the SA circuit 140 to perform a first read operation, and the threshold setting circuit 120 may output a second threshold VT1 to the SA circuit 140 to perform a second read operation. In some embodiments, the first threshold VT0 is less than the normally-operating threshold VT, and the normally-operating threshold VT is less than the second threshold VT1. In some embodiments, the memory device 100 may perform a calibration process to generate the appropriate first threshold VT0 and the appropriate second threshold VT1 for the memory device 100. In other words, the first threshold VT0 and the second threshold VT1 may be set appropriately for different memory devices through the calibration process. The disclosure does not intend to limit the circuit structure of the threshold setting circuit 120. Please note that each of the first threshold VT1 and the second threshold VT2 can be a threshold voltage or a threshold current, depending on the implementation of the memory device 100.

The SA circuit 140 is configured to receive a threshold from the threshold setting circuit 120 and is configured to read data stored in the memory cells MC using the received threshold. The SA circuit 140 may sense charge voltages at the bit lines connected to the memory cells MC and compare the sensed charge voltages with the threshold to generate read values. During the normal operating mode, the SA circuit 140 may compare the sensed charge voltages from the bit lines with the threshold VT to generate read values D. During the marginal monitoring mode, the SA circuit 140 may compare the sensed charge voltages from the bit lines with the first threshold VT0 to generate the first read values D1, and the SA circuit 140 may further compare the sensed charge voltages with the second threshold VT1 to generate the second read values D2. The SA circuit 140 may output the first read values D1 and the second read values D2 to the BIST circuit 130 in the marginal monitoring mode. The SA circuit 140 can perform the first and second read operations sequentially or simultaneously to obtain the first read values D1 and the second read values D2. In an embodiment, the SA circuit 140 may sequentially perform two consecutive read operations using the first and second threshold VT0 and VT1 to obtain the first and read values D1 and D2. In an alternative embodiment, the SA circuit 140 may include two set of sense amplifiers for simultaneously performing two read operations using the first and second threshold VT0 and VT1 to obtain the first and read values D1 and D2.

The BIST circuit 130 is connected to the memory array 110, the threshold setting circuit 120, and the SA circuit 140 to control the memory array 110, the threshold setting circuit 120, and the SA circuit 140. The BIST circuit 130 may output a read command CMD and the address ADDR to the memory array 110 to perform the read operation. In an embodiment, the BIST circuit 130 may receive the read command CMD from the UI 150 and transmit the received read command CMD to the memory array 110. In an alternative embodiment, the BIST circuit 130 may generate the read command CMD and transmit the generated read command CMD to the memory array 110.

The BIST circuit 130 is further configured to output a threshold selecting signal VT_SEL to the threshold setting circuit 120 to output thresholds for read operations. During the normal operating mode, the BIST circuit 130 may control the threshold setting circuit 120 to output the threshold VT to the SA circuit 140. During the marginal monitoring mode, the BIST circuit 130 may control the threshold setting circuit 120 to output the thresholds VT1 and VT2 to the SA circuit 140.

The BIST circuit 130 is connected to the SA circuit 140 to receive the read values from the SA circuit 140. The BIST circuit 130 may receive the read value D in the normal operating mode and may receive the first read value D1 and the second read value D2 in the marginal monitoring mode. The read value D, D1 and D2 may be received sequentially or simultaneously, depending on implementation. The BIST circuit 130 may perform processing on the first and second read values D1 and D2 received from the SA circuit 140 for monitoring the health of the memory cells in the memory array 110.

In some embodiments, during the marginal monitoring mode, the BIST circuit 130 may perform a first read operation on a memory cell using the first threshold VT0 to generate the first read value D1, and perform a second read operation on the same memory cell using the second threshold VT1 to generate the second read value D2. The BIST circuit 130 may compare the first read value D1 with the second read value D2 to determine whether the memory cell is marginal. When the first read value D1 is identical to the second read value D2, the BIST circuit 130 determines that the memory cell is not marginal. When the first read value D1 differs from the second read value D2, the BIST circuit 130 determines that the memory cell is marginal. The memory cell is considered marginal when there is insufficient margin between the charge voltage in the memory cell and the normally-operating threshold VT to prevent ambiguity. In other words, the memory cell is marginal when the charge voltage stored in the memory cell is too close to the normally-operating threshold VT. When the charge voltage stored in the memory cell is too close to the normally-operating threshold VT, the bit value stored in the memory cell might flip, potentially leading to a failure in the memory device 100. By comparing the first read value D1 obtained by reading the memory cell using the first threshold VT0 and the second read value D2 obtained by reading the memory cell using the second threshold VT1, the BIST circuit 130 or a user may monitor the marginal status of each memory cell in the memory device 100. In other words, the BIST circuit 130 may monitor the health of the memory cells of the memory device 100. In some embodiments, the memory device 100 does not include the dedicated BIST circuit 130, and the functionalities of the BIST circuit 130 can be replaced or implemented by a user via the UI 150. The user may control reading the data from the memory cells of the memory device 100 while controlling the thresholds (i.e., first and second thresholds) to obtain the read values (i.e., first read value D1 and the second read value D2). The user may control to compare the read values to determine if the memory cell is marginal.

An execution of this marginal monitoring mode could be triggered by a dedicated user command or automatically whenever the device is idle, e.g., it can be executed before the device is powered down. This marginal monitoring mode can be used to periodically scan the entire memory device or specific regions of the memory device. Different memory scanning strategies can be applied, depending on the application of the memory device. One method could involve scanning all addresses of the memory device in linear order, although this may require the non-volatile memory to register progress over multiple sessions. Another method could involve randomly selecting an address or a block for scanning.

It is noted that monitoring the health of the memory cells in a unit of memory cells may take a significant amount of time and require large storage space for storing the read values and comparison results, especially when the number of memory cells in the memory device 100 is large. It is possible to perform the marginal monitoring in a unit of memory blocks, which includes a plurality of memory cells, to reduce the amount of time and storage space required for executing the marginal monitoring. For example, the BIST circuit 130 may calculate a checksum value of read values from the memory block, a hash value of read values from the memory block, or utilize an error correction code (ECC) function to perform the marginal monitoring. It is noted that the number of memory cells included in each memory block can vary based on the design requirements.

In an embodiment, the BIST circuit 130 may compare checksum values of a memory block to determine a marginal status of the memory block. The BIST circuit 130 may perform a first read operation on the memory block using the first threshold VT0 to obtain first read values D1 and perform a second read operation on the memory block using the second threshold VT1 to obtain second read values D2. Next, the BIST circuit 130 may perform a first checksum operation on the first read values D1 to obtain a first checksum value and to perform a second checksum operation on the second read values to obtain a second checksum value. The BIST circuit 130 may compare the first checksum value with the second checksum value to determine whether the block of memory cells is marginal. When the first checksum value is identical to the second checksum value, the BIST circuit 130 determines that the memory block is not marginal. When the first checksum value differs from the second checksum value, the BIST circuit 130 determines that the memory block is marginal.

The first and second checksum operations may be performed in accordance with different checksum algorithms, such as a simple summation, logic operation (i.e., exclusive OR operation), cyclic redundancy check (CRC) algorithms or the like.

In some embodiments, the BIST circuit 130 may compare hash values of a memory block to determine the marginal status of the memory block. The BIST circuit 130 may perform a first read operation on the memory block using the first threshold VT0 to obtain first read values D1 and perform a second read operation on the memory block using the second threshold VT1 to obtain second read values D2. The BIST circuit 130 may perform a first hash operation on the first read values D1 to obtain a first hash value and perform a second hash operation on the second read values to obtain a second hash value. The BIST circuit 130 may compare the first hash value with the second hash value to determine whether the block of memory cells is marginal. When the first hash value is identical to the second hash value, the BIST circuit 130 determines that the memory block is not marginal. When the first hash value is different from the second hash value, the BIST circuit 130 determines that the memory block is marginal. The first and second hash operations may be performed in accordance with different hash algorithms. Examples of the hash algorithms may include message digest algorithm 5 (MD5), secure hash algorithm 1 (SHA-1), secure hash algorithm 256-bit (SHA-256), secure hash algorithm 512-bit (SHA-512), and the like. Please note that the disclosure does not intend to limit the hash algorithms that can be used in the disclosure. Additionally, one of ordinary skill in the technical field will be clear about the operations of these hash algorithms.

In some embodiments, the BIST circuit 130 may utilize an error correction code (ECC) function of the memory device 100 to perform the marginal monitoring on the memory device 100. The ECC function is typically designed to detect and correct errors over specific segments of memory (i.e., 128-bit memory segment). The ECC function can detect up to two error bits in a memory line. In some embodiments, the BIST circuit 130 may utilize the ECC function of the memory device 100 to detect an error in the memory cells of the memory device 100. If there is an error detected by the ECC function, the BIST circuit 130 determines that the memory cells are marginal. If the ECC function does not detect any error in the memory device, the BIST circuit 130 may determine that the memory cells are not marginal. The ECC function may be included in the BIST circuit 130 or may be included in another circuit of the memory device 100. An operation of the ECC function in a memory device is well recognized in the technical field, thus a detailed description of the ECC function of the memory device 100 is omitted hereafter.

In some embodiments, the BIST circuit 130 may include a temporary storage 131 and a comparator 133. The temporary storage 131 may store the read values from the SA circuit 140. During the marginal monitoring mode, the temporary storage 131 may store the read values (i.e., first read value D1 and second read value D2), the checksum values, the hash values, and/or data from the ECC function. The temporary storage 131 may also store the comparison result generated by the comparator 133.

The comparator 133 is connected to the temporary storage 131 and is configured to compare the values stored in the temporary storage 131. The comparator 133 may compare the first read value D1 with the second read value D2 to obtain a comparison result. The first read value D1 is obtained by reading at least one memory cell using the first threshold VT0, and the second read value D2 is obtained by reading at least one memory cell using the second threshold VT1. In some embodiments, the comparator 133 may compare the first checksum value with the second checksum value, where the first checksum value is obtained by performing the first checksum operation on the first read values of the memory block, and the second checksum value is obtained by performing the second checksum operation on the second read values of the memory block. In some embodiments, the comparator 133 is configured to compare the first hash value with the second hash value, where the first hash value is obtained by performing the first hash operation on the first read values of the memory block, and the second hash value is obtained by performing the second hash operation on the second read values of the memory block. It is appreciated that the circuit structure of the comparator 133 is not limited to any particular circuit structure. Additionally, the BIST circuit 130 may further include other circuits (not shown) that are configured to perform the checksum operation, the CRC operation, or the hash operation.

The UI 150 is connected to the BIST circuit 130 and is configured to communicate with the BIST circuit 130. The UI 150 may receive a status signal STA, which indicates the marginal status of the memory cells of the memory device 100 from the BIST circuit 130. The UI 150 may also send read commands CMD for performing the read operations on the memory cells of the memory device 100 to the BIST circuit 130. In an embodiment, the UI 150 may communicate with an external device (not shown) such as a host system on chip (SoC) to receive the read commands CMD from the external device and to output the marginal status STA to the external device.

The memory device 100 may perform corrective measures or corrective operations to correct the marginal memory cells. The corrective measures may be designed to restore the proper functionality of the marginal memory cells. In some embodiments, the memory device 100 may re-program the marginal memory cells to set the charge voltages of the marginal memory cells to proper charge voltages. In some embodiments, the memory device 100 may re-program the entire erasable sector or the erase unit containing the marginal memory cells. For example, the memory device 100 may copy data from the entire erase unit (e.g., 4KB erase unit) to a temporary memory, erase the erase unit of memory where the marginal condition was detected, and then copy the data back to the erased erase unit. In some embodiments, the memory device 100 may generate a notification to notify a user about the marginal condition of the memory device, and the memory device 100 may perform the corrective measures or corrective operations in accordance with the user's instructions.

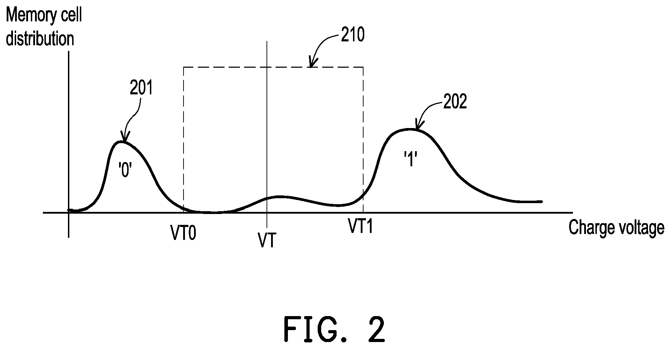

FIG. 2 is a diagram illustrating a charge voltage distribution of memory cells in a memory device (i.e., the memory device 100 in FIG. 1) in accordance with some embodiments. The vertical axis of the diagram indicates a memory cell distribution in the memory device, and the horizontal axis of the diagram indicates charge voltages of the memory cells. The memory cells with charge voltages less than a first threshold VT0 may have a first logic value (i.e., logic value "0"), and the memory cells with charge voltages greater than a second threshold VT1 may have a second logic value (i.e., logic value "1"). The diagram in FIG. 2 further shows a marginal zone 210, which is within a range from the first threshold VT0 to the second threshold VT1. If the memory cells of the memory device 100 have sufficient margin, the charge voltages of the memory cells should either be less than the first threshold VT0 or greater than the second threshold VT1. When the charge voltage of a memory cell falls within the range from the first threshold VT0 to the second threshold VT1, the margin between the charge voltage of the memory cell and a read threshold may be insufficient to prevent ambiguity. The read threshold refers to a threshold that is used in reading operations in the normal operating mode of the memory device 100. When the charge voltage of a memory cell falls within the marginal zone 210, the memory cell is determined to be marginal. The BIST circuit 130 of the memory device 100 in the disclosure may determine whether the charge voltages of the memory cells fall within the marginal zone 210, thereby determining the marginal status of the memory cells. As such, the memory device 100 may perform in-field monitoring of the health of the memory cells of the memory device 100. Furthermore, the memory device 100 may be configured to further perform corrective measures, such as performing re-programming operations on the marginal memory cells or outputting a notification regarding the marginal memory cells.

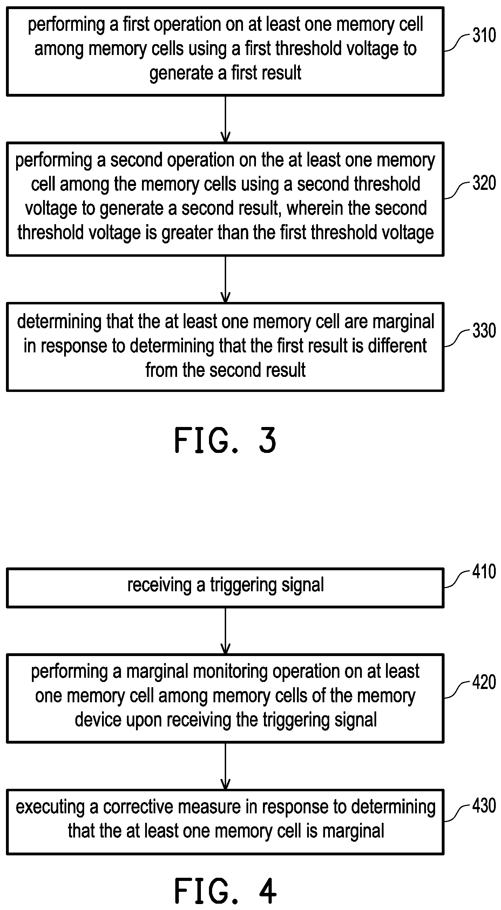

FIG. 3 is a flowchart diagram illustrating a marginal monitoring operation of an operating method adapted to a memory device (i.e., the memory device 100 in FIG. 1) in accordance with some embodiments. In step 310, a first operation is performed on at least one memory cell among the memory cells of the memory device using a first threshold to generate a first result. In step 320, a second operation is performed on the at least one memory cell among the memory cells using a second threshold to generate a second result. The second threshold is greater than the first threshold. In step 330, it is determined that the at least one memory cell is marginal in response to determining that the first result is different from the second result.

FIG. 4 is a flowchart diagram illustrating an operating method adapted to a memory device (i.e., the memory device 100 in FIG. 1) in accordance with some embodiments. In step 410, a triggering signal is received by the memory device. In step 420, a marginal monitoring operation is performed on at least one memory cell among the memory cells of the memory device upon receiving the triggering signal. The marginal monitoring operation may be performed by performing the steps 310 to 330 in FIG. 3. In step 430, a corrective measure is executed in response to determining that the at least one memory cell is marginal.

In accordance with the embodiments of the disclosure, an operating method adapted to a memory device is introduced to predict the health of memory cells before a failure occurs in the memory cells. The operating method can be used to test memory health and predict failures during the device lifetime. The operating method may detect conditions where there is insufficient margin between charge voltages stored in the memory cells and a threshold to prevent ambiguity. The operating method may compare a first read value of a memory cell with a second read value of the memory cell to determine the marginal status of the memory cell. As such, the operating method may predict the health of the memory cell of the memory device before a failure occurs in the memory device. Since the marginal monitoring operation may be implemented and executed in-field, the health of the memory cell of the memory device may be monitored even after the memory device is shipped. Furthermore, corrective measures such as reprogramming the marginal memory cell or reprogramming the entire erase block containing the marginal memory cell may be performed to restore the proper functionality of the marginal memory cells. In this way, the disclosure may increase reliability and stability for safety-critical applications. Additionally, it may reduce statistical margins required to ensure endurance and data retention of memory cells, thereby increasing yield and reducing the die size of the memory device.

Additionally, the operating method may be performed in a unit of memory block including a plurality of memory cells to reduce the amount of time and storage space for executing this operating method. The operating method may compare a first checksum value (or a first hash value) obtained from first read values of a memory block with a second checksum value (or a second hash value) obtained from second read values of the memory block to determine the marginal status of the memory block. The operating method may also utilize the ECC function of the memory device to determine the marginal status of the memory block.

## Claims

1. An operating method adapted to a memory device (100) comprising a plurality of memory cells (MC), the operating method comprising:
performing a marginal monitoring operation on at least one memory cell among the memory cells of the memory device, the marginal monitoring operation comprising:
performing a first operation on the at least one memory cell among the memory cells using a first threshold to generate a first result (310);
performing a second operation on the at least one memory cell among the memory cells using a second threshold to generate a second result, wherein the second threshold is greater than the first threshold (320); and
determining that the at least one memory cell are marginal in response to determining that the first result is different from the second result (330).

2. The operating method of claim 1, wherein each of the first operation and the second operation is a read operation on a memory cell, and performing the first operation and the second memory operation comprises:
performing a first read operation on the memory cell using the first threshold to obtain a first read value; and
performing a second read operation on the memory cell using the second threshold to obtain a second read value,
wherein the at least one memory cell is marginal in response to determining that the first read value is different from the second read value.

3. The operating method of claim 1, wherein performing the first operation and the second memory operation comprises:
performing a first read operation on the memory block using the first threshold to obtain first read values;
performing one of the following steps:
performing a first checksum operation on the first read values to obtain a first checksum value;
performing an error detection using an error correction code (ECC) function of the memory device to detect an error in the first read values; and
performing a first hash operation on the first read values to obtain a first hash value; and
performing a second read operation on the memory block using the second threshold to obtain second read values; and
performing one of the following steps:
performing a second checksum operation on the second read values to obtain the second checksum value;
performing a second hash operation on the second read values to obtain a second hash value; and
performing the error detection using the ECC function of the memory device to detect an error in the second read values,
wherein the memory block is marginal in response to determining that the error is detected in the first read values or the second read values.

4. The operating method of claim 1, wherein
during a normal operation of the memory device, a threshold is used to perform a read operation on the memory cells of the memory device,
the threshold is greater than the first threshold, and
the threshold is less than the second threshold.

5. The operating method of claim 1, further comprising:
performing a calibration process on the memory device to determine the first threshold and the second threshold.

6. The operating method of claim 1, further comprising:
receiving a triggering signal before performing the marginal monitoring operation, wherein the marginal monitoring operation is performed upon receiving the triggering signal; and
executing a corrective measure in response to determining that the at least one memory cell is marginal.

7. The operating method of claim 6, wherein the triggering condition comprises a user command or a predetermined status of the memory device.

8. The operating method of claim 1, wherein
the at least one memory cell for the marginal monitoring operation is randomly selected among the memory cells.

9. The operating method of claim 1, wherein
the at least one memory cell for the marginal monitoring operation include all the memory cells of the memory device.

10. The operating method of claim 6, wherein
the corrective measure comprises a program operation which is configured to re-program the at least one memory cell determined as marginal.

11. The operating method of claim 6, wherein
the corrective measure comprises a program operation which is configured to copy data of a memory block containing the at least one memory cell determined as marginal to a temporary memory block, erasing the memory block containing the at least one memory cell determined as marginal to be an erased memory block, and copy the data from the temporary memory block back to the erased memory block.

12. A memory device (100), comprising:
a memory array (110), comprising a plurality of memory cells (MC);
a sense amplifier (140), connected to the memory cells, configured to read values stored in the memory cells;
a built-in self-test (BIST) circuit (130), connected to the memory cells, configured to:
perform a first operation on at least one memory cell among the memory cells using a first threshold (VT0) to generate a first result;
perform a second operation on the at least one memory cell among the memory cells using a second threshold (VT1) to generate a second result, wherein the second threshold is greater than the first threshold; and
determine that the at least one memory cell are marginal in response to determining that the first result is different from the second result.

13. The memory device (100) of claim 12, wherein the BIST circuit (130) comprises:
a temporary storage (131), configured to store the first result and the second result of the first operation and the second operation; and
a comparator (133), connected to the temporary storage, configured to compare the first result with the second result.

14. The memory device (100) of claim 12, further comprising:
a user interface (150), connected to the BIST circuit (130), configured to receive a marginal status (STA) from the BIST circuit and to output a read command (CMD) to the BIST circuit (130), and
a threshold setting circuit (120), receiving a threshold selecting signal (VT_SEL) from the BIST circuit and generate the first threshold and the second threshold according to the threshold selecting signal.

15. The memory device (100) of claim 12, wherein the BIST circuit is further configured to:
perform a first read operation on a memory cell using the first threshold to obtain a first read value;
perform a second read operation on the memory cell using the second threshold to obtain the second first read value; and
determine that the memory is marginal in response to determining that the first read value is different from the second read value.
